# FASCICULE DE BREVET EUROPEEN

(11) **EP 2 159 915 B1**
(45) Date de publication et mention de la délivrance du brevet: **19.03.2014**
(21) Numéro de dépôt: 09168293.0
(22) Date de dépôt: 20.08.2009
(51) Int. Cl.: H03F 3/60, H03F 3/72

(54) **Dispositif hyperfréquence large bande à gain commutable**
Mikrowellen-Breitbandvorrichtung mit veränderlicher Verstärkung
Broadband microwave frequency device with switching gain

(30) Priorité: 29.08.2008 FR 0804764
(43) Date de publication de la demande: 03.03.2010
(73) Titulaire: Thales, 92200 Neuilly Sur Seine (FR)
(72) Inventeur: Plaze, Jean-Philippe, 78390 Bois d'Arcy (FR); Auric, Claude, 78117 Châteaufort (FR); Dueme, Philippe, 91400 Orsay (FR)
(74) Mandataire: Lucas, Laurent Jacques

(56) Documents cités:
- EP-A- 1 345 322
- GB-A- 2 219 702
- US-A- 4 755 769
- US-A- 6 094 099
- US-A1- 2004 056 710

## Description

L'invention concerne un dispositif actif large bande pour circuits intégrés hyperfréquences assurant des fonctions de commutation de gain.

Les chaînes d'émission et de réception réalisées par exemple en technologie MMIC (Monolithic Microwave Integrated Circuits, en langue anglaise), comportent généralement une ou plusieurs cellules de commande de gain permettant d'adapter, par exemple, dans le cas d'une chaîne d'émission radiofréquences le niveau de sortie souhaité et, dans le cas d'une chaîne de réception, le gain de la chaîne au niveau du signal reçu.

Un exemple d'amplificateur avec commande de gain peut être trouvé dans le document de brevet US 4,755,769.

En pratique, on cherche à obtenir un contrôle de gain de la chaîne d'émission et/ou de réception avec un minimum de distorsion du signal traité par la chaîne et de dégradation du facteur de bruit.

Actuellement plusieurs solutions existent dans l'état de l'art des circuits intégrés pour régler le niveau du signal dans une chaîne hyperfréquence :
- soit par l'utilisation d'un amplificateur qui sera commuté selon que l'on souhaite ou non une amplification du signal dans la chaîne,
- soit par l'utilisation d'un atténuateur qui sera activé ou pas suivant qu'il soit nécessaire ou pas d'affaiblir le signal dans la chaîne hyperfréquence.

Le choix de l'amplification ou de l'atténuation du signal dans la chaîne conduit généralement à insérer l'amplificateur ou l'atténuateur entre deux commutateurs commandés simultanément permettant de choisir pour le signal une voie parmi deux, de façon à activer ou pas la fonction en question.

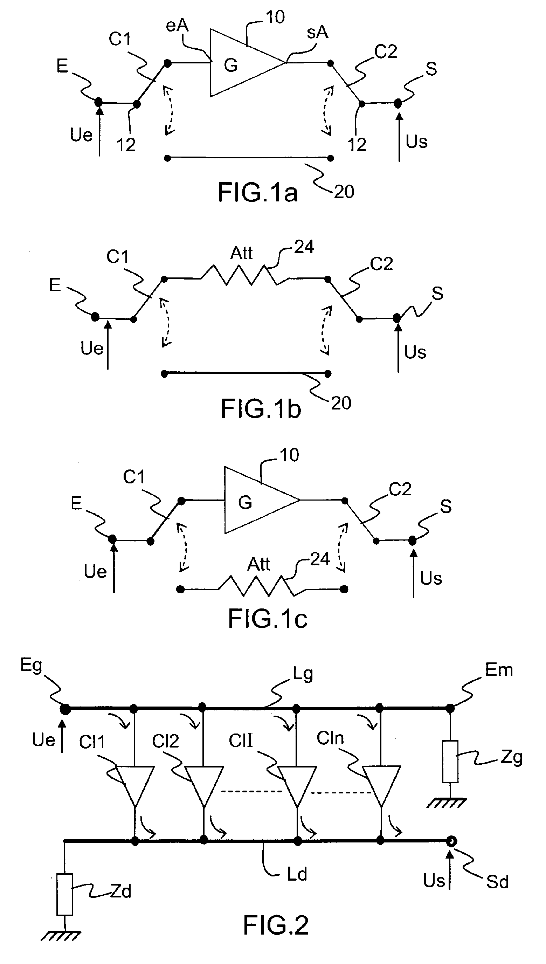

Les figures 1a et 1b montrent des dispositifs électroniques de réglage de gain de l'état de l'art dans une chaîne hyperfréquences. Ces dispositifs de réglage de gain sont aussi désignés respectivement par le terme « plots de gain » ou « plots d'atténuation ».

La figure 1a montre le cas d'utilisation d'un amplificateur hyperfréquence G 10 entre deux commutateurs commandés simultanément afin de permettre de choisir pour le signal une voie parmi deux, un commutateur d'entrée C1 et un commutateur de sortie C2. Les points communs 12 des commutateurs C1, C2 sont respectivement reliées, l'un à l'entrée E du dispositif et, l'autre à la sortie S du dispositif.

Les commutateurs C1 et C2, mis en position d'amplification, appliquent respectivement un signal d'entrée Ue reçu à l'entrée E du dispositif électronique de réglage de gain, à une entrée eA de l'amplificateur et un signal de sortie Us fournit par une sortie sA de l'amplificateur, à la sortie S du dispositif.

En position de transmission sans amplification du signal d'entrée Ue vers la sortie S du dispositif, les commutateurs C1 et C2 relient directement l'entrée E à la sortie S par un conducteur 20, donc sans aucune amplification mais avec des pertes de transmission apportées par les commutateurs et les connexions électriques.

La figure 1b montre un dispositif de réglage de gain avec les commutateurs C1, C2 tels que représentés à la figure 1a mais utilisant un atténuateur Att 24 à la place de l'amplificateur G 10.

Dans le cas où ces dispositifs de réglage de gain de l'état de l'art sont placés près d'une antenne de réception, par exemple pour attaquer un récepteur radiofréquences, le dispositif amplificateur de la figure 1a est privilégié pour ne pas dégrader le facteur de bruit NF du récepteur.

Néanmoins, l'utilisation de commutateurs C1, C2 pour réaliser la fonction de la figure 1a entraîne, par les pertes hautes fréquences qu'ils introduisent, une dégradation du facteur de bruit NF du récepteur. En effet les commutateurs étant des structures passives, les pertes du commutateur d'entrée C1 (exprimées en dB) viennent directement se sommer au facteur de bruit NF (en dB) du reste du dispositif, soit de l'amplificateur G 10 et du commutateur C2 relié à la sortie S du dispositif.

En outre, l'utilisation de deux commutateurs C1 et C2 pour réaliser ces dispositifs de réglage de gain conduit à une augmentation des pertes de la chaîne hyperfréquences quelque soit la configuration du dispositif (ou le chemin parcouru par le signal dans la chaîne) soit à gain maximum ou à gain minimum. En effet, sur l'ensemble des deux dispositifs assurant des fonctions de réglage de gain des figures 1a et 1b, seules les pertes des commutateurs C1 et C2 dans le mode d'atténuation de la figure 1b, peuvent être compensées par une réduction équivalente de la valeur de l'atténuateur Att, mais cela se fait alors au détriment de la différence de gain entre les deux voies commutées (voie de transmission directe par le conducteur 20 et voie d'atténuation par l'atténuateur Att).

La figure 1c montre un dispositif de réglage de gain avec les commutateurs C1, C2 tels que représentés aux figures 1a et 1b comportant également deux voies commutées. La première voie contient un amplificateur G 10, la seconde un atténuateur Att 24. Cette solution permet d'augmenter, si besoin est, la différence de gain entre les deux états du dispositif mais ne change rien à l'inconvénient de l'augmentation du facteur de bruit due aux pertes du commutateur d'entrée C1.

Dans le cas d'une chaîne de réception radiofréquences utilisant plusieurs dispositifs de réglage de gain pour gérer la dynamique du signal dans la chaîne radiofréquences, il s'avère nécessaire, au final, d'ajouter un ou plusieurs autres amplificateurs pour compenser l'ensemble des pertes de ces dispositifs.

Dans l'état de l'art des récepteurs radiofréquences, il n'existe pas de solution idéale pour éviter une dégradation du facteur de bruit.

Pour obtenir néanmoins un bon facteur de bruit NF, les chaînes de réception de l'état de l'art comportent habituellement un amplificateur à faible bruit (LNA) en tête de la chaîne de réception, sans possibilité de le commuter, ce qui comporte l'inconvénient, dans le cas de réception de signaux de forts niveaux, d'introduire des distorsions du signal reçu mais aussi une dégradation des caractéristiques du récepteur, voire une destruction de celui-ci.

Pour palier les inconvénients des dispositifs de réglage de gain de l'état de l'art, l'invention propose un dispositif hyperfréquence large bande à gain commutable comportant une entrée E et une sortie S de signal hyperfréquence, un amplificateur distribué à n cellules amplificatrices (Cl1, Cl2,...Cli,...Cln) comportant une ligne de transmission d'entrée (Lg) d'un signal d'entrée Ue appliqué à l'entrée E de signal hyperfréquence, ladite ligne de transmission d'entrée ayant une de ses deux extrémités (ec1) reliée à l'entrée E de signal hyperfréquence, une ligne de transmission de sortie (Ld) dudit signal d'entrée Ue amplifié ayant une extrémité (Sd) de sortie de l'amplificateur distribué, les cellules amplificatrices de l'amplificateur distribué pouvant être mises soit dans un état amplificateur, soit dans un état bloqué,
**caractérisé en ce qu**'il comporte un commutateur deux voies vers une voie (C2) comportant une entrée de contrôle pour être commuté, soit dans une position de non amplification reliant alors la sortie S de signal hyperfréquence à l'autre extrémité (Em) de la ligne de transmission d'entrée (Lg) pour transmettre à ladite sortie S le signal d'entrée (Ue), soit dans une position d'amplification reliant ladite sortie S de signal à l'extrémité (Sd) de sortie de l'amplificateur distribué pour transmettre à la sortie S de signal hyperfréquences un signal d'entrée (Ue) amplifié, une unité de commande UC fournissant des signaux de commande de position du commutateur deux voies vers une voie (C2) et d'état des cellules amplificatrices.

Avantageusement, chaque cellule amplificatrice comporte une entrée et une sortie hyperfréquences de signal amplifié, une entrée de commande pour être mise, soit dans l'état amplificateur et fournir un signal amplifié en sortie hyperfréquences de la cellule, soit dans l'état bloqué pour isoler la sortie de la cellule de son entrée.

Dans une réalisation, le dispositif comporte une impédance de fermeture (Zg) et en ce que, lorsque le commutateur deux voies vers une voie (C2) est dans la position d'amplification, les cellules amplificatrices sont mises dans l'état amplificateur, l'autre extrémité (Em) de la ligne de transmission d'entrée (Lg) étant connectée à un potentiel de référence (M) par l'intermédiaire de l'impédance de fermeture (Zg) et, lorsque le commutateur est dans la position de non amplification, les cellules amplificatrices sont mises dans l'état bloqué, l'extrémité (Em) de la ligne de transmission d'entrée (Lg) étant alors déconnectée de l'impédance de fermeture (Zg).

Dans un exemple de réalisation, chaque cellule amplificatrice est réalisée à base de transistors tels que les transistors bipolaires ou les transistors à effet de champ.

Dans une autre réalisation, le commutateur (C2) est réalisé par au moins deux transistors.

Dans un autre exemple de réalisation du dispositif, le commutateur (C2) est réalisé à l'aide de deux transistors à effet de champ (TECs) froids, un TEC T1 connecté par son drain D à l'autre extrémité (Em) de la ligne de transmission d'entrée (Lg) du signal d'entrée et par sa source S à la sortie S de signal hyperfréquences, un TEC T2 connecté par son drain D à l'extrémité (Sd) de sortie de l'amplificateur distribué et par sa source S à ladite sortie S de signal hyperfréquences et, un TEC T3 est connecté par son drain au point commun entre l'extrémité (Em) de la ligne de transmission d'entrée (Lg) et le drain du TEC T1 par l'intermédiaire d'une impédance de fermeture (Zg) de la ligne de transmission d'entrée (Lg) et, par sa source, à un potentiel de référence (M).

Les TECs froids sont des transistors à effet de champ dont la tension continue entre le drain et la source est toujours nulle,

L'invention propose de supprimer le commutateur d'entrée C1 des dispositifs de réglage de gain de l'état de l'art par une solution consistant à utiliser les caractéristiques physiques d'un amplificateur distribué.

La figure 2 montre un schéma d'un amplificateur distribué simple de l'état de l'art comportant n cellules amplificatrices Cl1, Cl2,...Cli,...Cln, (i étant un nombre compris entre 1 et n) par exemple réalisées à partir des transistors à effet de champ (TEC). L'amplificateur distribué comporte une entrée Eg et une sortie Sd radiofréquences large bande.

L'amplificateur distribué simple de la figure 2 comporte une ligne de transmission d'entrée Lg, reliée à l'entrée Eg, couplée activement à une ligne de transmission de sortie Ld par l'intermédiaire des cellules actives Cli. Dans le cas particulier de réalisation des cellules actives Cli avec des transistors à effet de champ (TEC), la ligne de transmission d'entrée Lg peut être aussi désignée « ligne de grille », puisque ce sont alors les grilles des transistors des cellules amplificatrices qui y sont connectées et, dans ce même cas, la ligne de transmission de sortie Ld peut être appelée « ligne de drain » puisque ce sont les drains des transistors des dites cellules amplificatrices qui y sont connectés.

Le couplage actif entre ces deux lignes Lg et Ld peut être réalisé soit par des transistors seuls soit par des cellules amplificatrices plus complexes, par exemple, un montage cascode ou un montage cascade.

Les lignes de grille Lg et de drain Ld sont chargées chacune par une impédance de fermeture, respectivement Zg et Zd contribuant à l'adaptation aux accès respectifs Eg et Sd du dispositif.

Dans une structure distribuée classique, un signal Ue radiofréquences entrant par une extrémité Eg de la ligne de grille Lg se propage le long de celle-ci et se couple activement à la ligne de drain Ld au travers des cellules amplificatrices Cl1, Cl2,...Cli,...Cln, réparties tout au long de ces deux lignes. Le signal d'entrée Ue amplifié en sortie des cellules amplificatrices se recombine en phase sur la ligne de drain Ld pour se propager vers la sortie Sd.

Un principal but de l'invention est de supprimer le commutateur d'entrée C1 des dispositifs de réglage de gain tels que décrits sur les figures 1a, 1b ou 1c.

Un autre but est d'obtenir un dispositif hyperfréquence de réglage de gain présentant un très faible facteur de bruit.

L'invention sera mieux comprise à l'aide d'exemples de réalisation de dispositif hyperfréquence large bande à gain commutable et d'un procédé pour sa mise en oeuvre, en référence aux dessins indexés dans lesquels :
- les figures 1a, 1b et 1c, déjà décrites, montrent des dispositifs électroniques de réglage de gain de l'état de l'art ;
- la figure 2, déjà décrite, montre un schéma d'un amplificateur distribué simple de l'état de l'art comportant n cellules amplificatrices ;
- les figures 3a et 3b montrent des schémas de principe des 2 modes de fonctionnement d'un dispositif hyperfréquence large bande à gain commutable selon l'invention ;
- la figure 4 montre un exemple de réalisation pratique d'un dispositif hyperfréquence large bande à gain commutable selon l'invention ;
- les figures 5a et 5b montrent respectivement des caractéristiques de gain suivant les 2 états de fonctionnement et la différence de gain entre ces 2 états de fonctionnement, en fonction de la fréquence de fonctionnement du dispositif hyperfréquence de la figure 4.

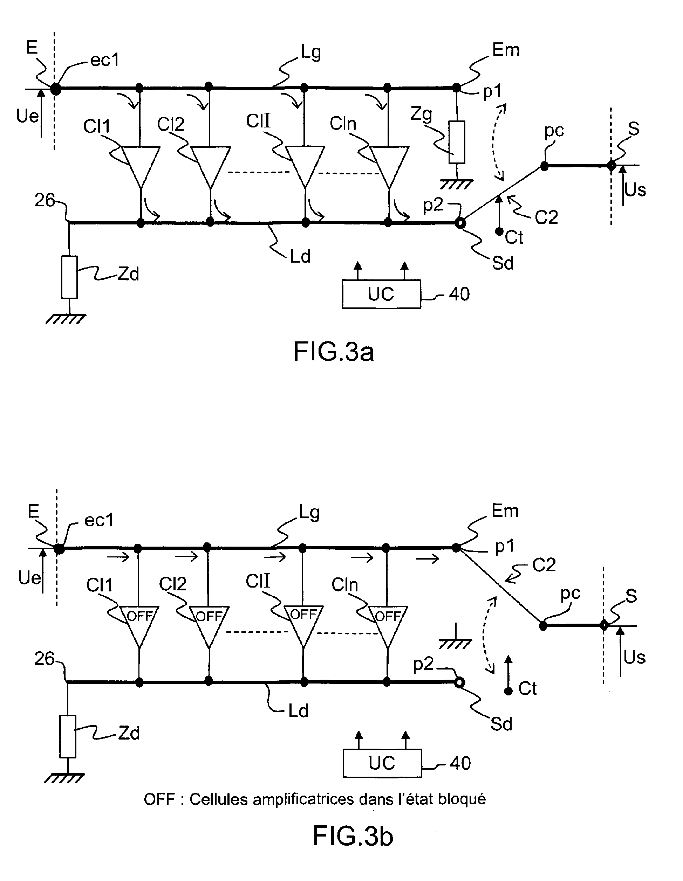

Le dispositif hyperfréquence large bande à gain commutable des figures 3a et 3b comporte :
- une entrée E et une sortie S hyperfréquences du dispositif,
- un amplificateur distribué à n cellules amplificatrices Cl1, Cl2,...Cli,...Cln, comportant une ligne de transmission d'entrée Lg d'un signal d'entrée Ue appliqué à l'entrée E de signal hyperfréquence et une ligne de transmission de sortie Ld du signal d'entrée amplifié ;
- un commutateur C2 de type deux voies vers une voie ayant un plot commun pc et deux plots p1, p2 pour le choix de la voie à commuter. Ce commutateur C2 sera désigné par la suite de façon plus simple, commutateur 2 vers 1.

La ligne de transmission d'entrée Lg a une de ses deux extrémités ec1 reliée à l'entrée E du dispositif et l'autre extrémité Em reliée d'une part, au plot p1 du commutateur C2, et d'autre part, à une impédance de fermeture commutable Zg. Par impédance de fermeture commutable Zg, on entend une impédance Zg associée à un moyen de commutation afin de pouvoir refermer ou pas la ligne de transmission d'entrée Lg sur cette impédance Zg.

La ligne de transmission de sortie Ld dudit signal d'entrée Ue amplifié par les n cellules amplificatrices a une extrémité Sd de sortie de l'amplificateur distribué reliée à l'autre plot p2 du commutateur C2. L'autre extrémité 26 de la ligne de transmission de sortie Ld est chargée par une impédance de fermeture Zd.

Le commutateur C2 comporte une entrée de contrôle Ct pour être commuté, soit dans une position de non amplification (voir figure 3b) le plot commun pc étant relié au plot p1 du commutateur C2, soit dans une position d'amplification (voir figure 3a) le plot commun pc étant relié au plot p2 du commutateur C2.

Dans l'amplificateur distribué du dispositif hyperfréquence large bande à gain commutable selon l'invention, il est nécessaire de modifier l'impédance de fermeture Zg de la ligne de transmission d'entrée Lg du signal d'entrée pour pouvoir la commuter et d'utiliser la structure distribuée associée à un commutateur en sortie pour effectuer la commutation entre l'état amplifié et l'état non-amplifié. Pour cela, l'amplificateur distribué doit présenter deux modes de fonctionnement.

La figure 3a montre le dispositif hyperfréquence large bande à gain commutable selon l'invention dans un premier mode de fonctionnement.

Le premier mode de fonctionnement est un mode amplificateur pour lequel les cellules amplificatrices Cl1, Cl2,...Cli,...Cln, sont activées (ou dans l'état amplificateur). Dans ce mode amplificateur, l'extrémité Sd de sortie de l'amplificateur distribué se trouve reliée, par le commutateur C2, à la sortie S du dispositif, pour transmettre à la sortie S hyperfréquences le signal d'entrée Ue amplifié par les cellules amplificatrices, soit le signal de sortie Us. En outre, dans ce mode amplificateur, la ligne de transmission d'entrée Lg du signal d'entrée est chargée à son autre extrémité Em par une impédance de fermeture Zg.

Dans le premier mode de fonctionnement, le signal radiofréquences d'entrée Ue, appliqué à l'entrée ec1 de l'amplificateur distribué, se propage le long de la ligne de transmission d'entrée Lg, se décompose en signaux élémentaires, chaque signal élémentaire est amplifié par une cellule active Cli, l'ensemble des signaux élémentaires amplifiés se recombinant en phase sur la ligne de transmission de sortie Ld vers l'extrémité Sd de celle-ci.

La figure 3b montre le dispositif hyperfréquence large bande à gain commutable selon l'invention dans un second mode de fonctionnement.

Le second mode de fonctionnement, ou mode non amplificateur, est un mode pour lequel les cellules amplificatrices de la structure distribuée sont éteintes, ou dans un état dit bloqué. Dans ce mode non amplificateur, l'autre extrémité Em de la ligne de transmission Lg du signal d'entrée Ue se trouve reliée, par le commutateur C2, à la sortie S du dispositif pour transmettre, sans amplification, le signal Ue appliqué à son entrée E.

Dans ce mode non amplificateur, la ligne de transmission d'entrée Lg est alors isolée de la ligne de transmission de sortie Ld. Le signal radiofréquences Ue entrant par l'entrée E du dispositif hyperfréquence se propage le long de la ligne de transmission d'entrée Lg et peut alors être récupéré à l'autre l'extrémité Em de celle-ci moyennant le fait de l'isoler de son impédance de fermeture Zg.

Le commutateur C2 idéalement placé entre l'extrémité Em de la ligne de transmission d'entrée Lg et l'extrémité de sortie Sd de la ligne de transmission de sortie Ld permet de récupérer, suivant sa position, soit le signal Ue amplifié, soit le signal Ue non amplifié (aux pertes de transmission près).

La position du commutateur C2 et l'état des cellules amplificatrices Cl1, Cl2,...Cli,...Cln, doivent être synchronisés. A cet effet, le dispositif hyperfréquence large bande à gain commutable comporte une unité de commande UC 40 fournissant des signaux de commande au commutateur C2, à l'impédance de fermeture commutable Zg et aux cellules amplificatrices Cli.

Dans un état de transmission sans amplification (ou de non amplification) du dispositif hyperfréquence (voir figure 3b) :
- l'unité de commande UC fournit simultanément, d'une part, une commande au commutateur C2 pour le mettre dans la position de non amplification reliant l' extrémité Em de la ligne de transmission d'entrée Lg du signal d'entrée à la sortie S du dispositif hyperfréquence, et une commande pour isoler l'impédance de fermeture commutable Zg de la ligne de transmission du signal d'entrée Lg et, d'autre part, une commande pour mettre toutes les cellules amplificatrices Cl1, Cl2,...Cli,...Cln, dans l'état bloqué isolant la première ligne de transmission Lg de la seconde ligne de transmission Ld.

Dans un état d'amplification du dispositif hyperfréquence large bande à gain commutable avec amplification du signal d'entrée Ue (voir figure 3a):
- l'unité de commande UC 40 fournit simultanément, au commutateur C2, à l'impédance de fermeture commutable Zg et aux cellules amplificatrices Cl1, Cl2,...Cli,...Cln, des commandes complémentaires pour mettre le commutateur C2 dans l'état amplificateur reliant l'extrémité de sortie Sd de la ligne de transmission de sortie Ld du signal d'entrée amplifié à la sortie S du dispositif hyperfréquence, pour connecter l'impédance de fermeture Zg à l'autre extrémité Em de la ligne de transmission d'entrée Lg et pour mettre toutes les cellules amplificatrices dans l'état amplificateur fournissant le signal d'entré amplifié (signal Us) à la sortie S du dispositif hyperfréquence.

Cette architecture de dispositif hyperfréquence large bande à gain commutable selon l'invention présente l'avantage de supprimer le commutateur C1 d'entrée dans la structure du plot de gain de l'état de l'art, ce qui a un impact direct, d'une part, sur le niveau de gain des voies amplifiée et non amplifiée (sans pour autant modifier la différence de gain entre ces voies) et surtout, sur le facteur de bruit NF du dispositif hyperfréquence puisque celui-ci est diminué du niveau de pertes du commutateur d'entrée C1 des dispositifs de l'état de l'art.

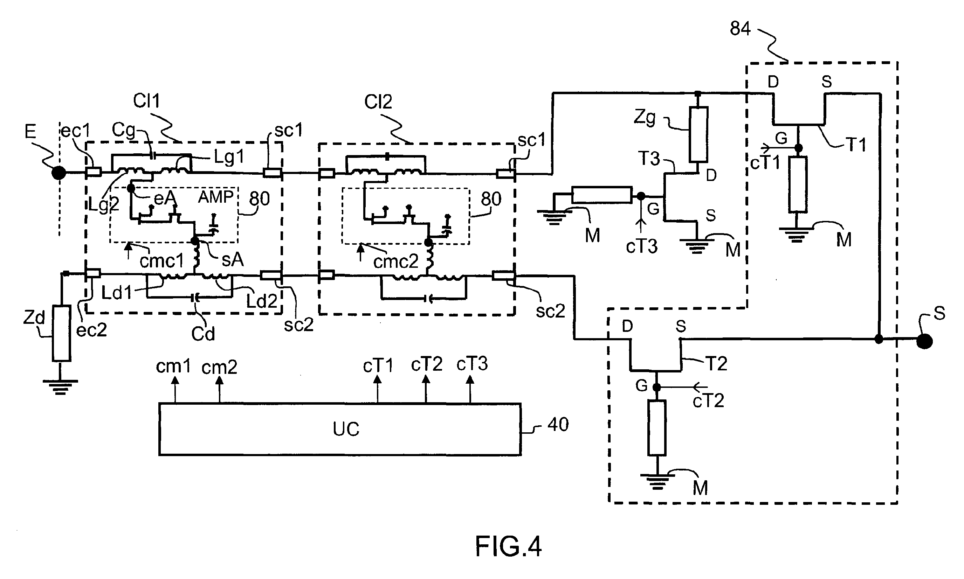

La figure 4 montre un exemple de réalisation pratique d'un dispositif hyperfréquence large bande à gain commutable selon l'invention.

Le dispositif hyperfréquence de la figure 4 comporte une première cellule Cl1 amplificatrice connectée en cascade avec une deuxième cellule Cl2 amplificatrice utilisant des transistors à effet de champ (TEC).

Chacune des deux cellules Cl1, Cl2 amplificatrices comporte, entre une entrée ec1 et une sortie sc1de la cellule, une demi-ligne de grille Lg formée par un condensateur Cg en parallèle avec deux selfs en série L1g, L2g. Entre une autre entrée ec2 et une autre sortie sc2, une demi-ligne de drain Ld de même structure que la demi-ligne de grille Lg du dispositif hyperfréquence comportant un autre condensateur Cd et deux autres selfs L1d, L2d, une cellule amplificatrice AMP 80 à transistors à effet de champ comportant une entrée eA et une sortie sA.

L'entrée eA de l'amplificateur est connectée au point commun entre les deux selfs L1 g, L2g, de la demi-ligne de grille Lg de la cellule considérée et sa sortie sA au point commun entre les deux selfs L1d, L2d, de la demi-ligne de drain Ld de ladite cellule.

Les deux cellules Cl1, Cl2 connectées en cascade forment un amplificateur distribué. A cet effet, l'entrée ec1 de la demi-ligne de grille de la première cellule Cl1 est connectée à l'entré E du dispositif hyperfréquence large bande à gain commutable, l'autre entrée ec2 de la demi ligne de drain de la première cellule Cl1 est connectée à une impédance de fermeture Zd de la ligne de drain.

La sortie sc1 de la demi-ligne de grille et celle sc2 de la demi-ligne de drain de la deuxième cellule Cl2 sont connectées à un circuit 84 de commutation à TEC froids réalisant le commutateur C2 des figures 3a et 3b. On entend par TEC froid un transistor à effet de champ pour lequel il n'y a pas de tension continue appliquée entre son drain D et sa source S. En fonction de la tension continue appliquée entre la grille G et la source S (ou le drain D) du transistor froid, celui-ci présente une résistance variable entre son drain et sa source ce qui lui confère les caractéristiques d'un interrupteur. D'autre part, la sortie sc1 de la demi-ligne de grille de la deuxième cellule Cl2 est également connectée à l'impédance de fermeture commutable Zg.

La sortie sc1 de la demi-ligne de grille et celle sc2 de la demi-ligne de drain de la première cellule Cl1 sont connectées respectivement à l'entrée ec1 de la demi-ligne de grille et l'entrée ec2 de la demi-ligne de drain de la deuxième cellule Cl2.

Le circuit de commutation 84, ou le commutateur C2, comporte un TEC froid T1 connecté par son drain D d'une part, à la sortie sc1 de la demi-ligne de grille de la deuxième cellule Cl2 et d'autre part, à une extrémité de l'impédance de fermeture Zg et par sa source S à la sortie S du dispositif hyperfréquence, un TEC froid T2 connecté par son drain D à la sortie sc2 de la demi-ligne de drain de la deuxième cellule Cl2 et par sa source S à ladite sortie S du dispositif hyperfréquence. Les TECs T1et T2 forment ainsi le commutateur C2 de type 2 vers 1 du dispositif hyperfréquence large bande à gain commutable.

Un autre TEC froid T3 est connecté, par son drain à l'autre extrémité de l'impédance de fermeture Zg de la ligne de transmission d'entré Lg du signal d'entrée et, par sa source à un potentiel de référence, par exemple une masse M du dispositif hyperfréquence large bande à gain commutable afin de permettre la commutation de l'impédance de fermeture Zg.

Chacune des deux cellules amplificatrices comporte une entrée de commande cmc1, cmc2 pour mettre les cellules amplificatrices AMP 80 soit dans un état amplificateur soit dans un état bloqué isolant ainsi leur entrée eA radiofréquence de leur sortie sA.

L'unité de commande UC fourni des signaux respectifs de commandes cT1, cT2, cT3 au niveau des grilles des TECs froids T1, T2, T3 ainsi que les signaux de commande cm1, cm2 pour attaquer les respectives entrées de commande cmc1, cmc2 des cellules amplificatrices AMP 80 et commander l'état des deux cellules Cl1, Cl2.

On peut rappeler que pour ce qui est des TECs froids T1, T2 et T3, l'électrode de grille G du TEC ne sert que comme électrode de commande et n'intervient pas directement dans le fonctionnement en hyperfréquence du circuit. Les TECs froids T1, T2 et T3 fonctionnent en interrupteurs et la source et le drain de chaque TEC froid dans le montage de la figure 4 peuvent être intervertis.

Dans cet exemple de réalisation, les cellules amplificatrices AMP 80 ainsi que le commutateur C2 sont réalisés à partir de transistors à effet de champ. Il est tout à fait envisageable de réaliser le dispositif selon l'invention avec d'autres types de transistors, tels que par exemple les transistors bipolaires, ou de réaliser les cellules amplificatrices avec un type de transistor et le commutateur C2 avec un autre type de transistor.

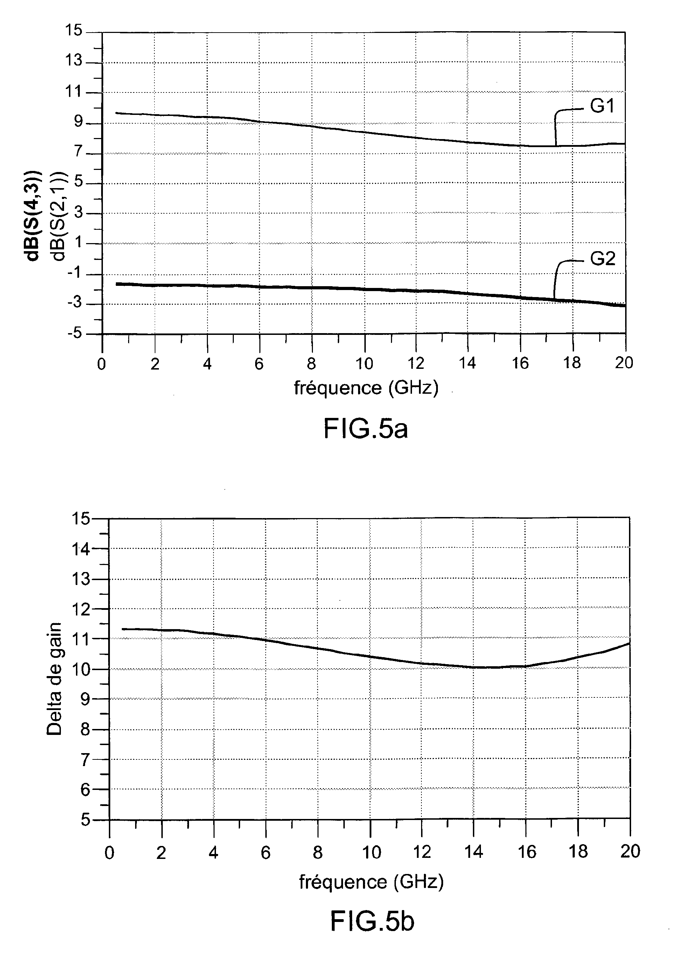

Les figures 5a et 5b montrent respectivement des caractéristiques de gain suivant les 2 états de fonctionnement et la différence de gain entre ces 2 états de fonctionnement, en fonction de la fréquence de fonctionnement du dispositif hyperfréquence large bande à gain commutable de la figure 4 selon l'invention.

La figure 5a comporte une première courbe G1 montrant la variation du gain (en dB) en fonction de la fréquence de fonctionnement (en GHz) du dispositif hyperfréquence selon l'invention commandée dans l'état d'amplification. La courbe G2 montre l'atténuation du dispositif hyperfréquence commandée dans l'état de non amplification. Cette atténuation représente les pertes de transmission de la ligne de grille Lg du dispositif et du circuit commutateur 84 lorsque celui-ci est en mode non amplification.

La figure 5b montre la différence de gain entre les deux modes de fonctionnement du dispositif.

## Revendications

1. Dispositif hyperfréquence large bande à gain commutable comportant une entrée E et une sortie S de signal hyperfréquence, un amplificateur distribué à n cellules amplificatrices (Cl1, Cl2,...Cli,...Cln) comportant une ligne de transmission d'entrée (Lg) d'un signal d'entrée (Ue) appliqué à l'entrée E de signal hyperfréquence, ladite ligne de transmission d'entrée ayant une de ses deux extrémités (ec1) reliée à l'entrée E de signal hyperfréquence, une ligne de transmission de sortie (Ld) dudit signal d'entrée (Ue) amplifié ayant une extrémité (Sd) de sortie de l'amplificateur distribué, les cellules amplificatrices de l'amplificateur distribué pouvant être mises soit dans un état amplificateur, soit dans un état bloqué,
**caractérisé en ce qu'**il comporte un commutateur deux voies vers une voie (C2) comportant une entrée de contrôle (Ct) pour être commuté, soit dans une position de non amplification reliant alors la sortie S de signal hyperfréquence à l'autre extrémité (Em) de la ligne de transmission d'entrée pour transmettre à ladite sortie S le signal d'entrée (Ue), soit dans une position d'amplification reliant ladite sortie S de signal à l'extrémité (Sd) de sortie de l'amplificateur distribué, pour transmettre à la sortie S de signal hyperfréquences un signal d'entrée (Ue) amplifié, une unité de commande UC fournissant des signaux de commande de position du commutateur deux voies vers une voie (C2) et d'état des cellules amplificatrices.

2. Dispositif hyperfréquence selon la revendication 1, **caractérisé en ce que** chaque cellule amplificatrice comporte une entrée (ec1) et une sortie (es1) hyperfréquences de signal amplifié, une entrée de commande (cmc1, cmc2) pour être mise, soit dans l'état amplificateur et fournir un signal amplifiée en sortie hyperfréquences de la cellule (sc2), soit dans l'état bloqué pour isoler la sortie (es1) de la cellule de son entrée (ec1).

3. Dispositif hyperfréquence selon l'une des revendications 1 ou 2, **caractérisé en ce qu'**il comporte une impédance de fermeture (Zg) et **en ce que**, lorsque le commutateur deux voies vers une voie (C2) est dans la position d'amplification, les cellules amplificatrices sont mises dans l'état amplificateur, l'autre extrémité (Em) de la ligne de transmission d'entrée (Lg) étant connectée à un potentiel de référence (M) par l'intermédiaire de l'impédance de fermeture (Zg) et, lorsque le commutateur est dans la position de non amplification, les cellules amplificatrices sont mises dans l'état bloqué, l'extrémité (Em) de la ligne de transmission d'entrée (Lg) étant alors déconnectée de l'impédance de fermeture (Zg).

4. Dispositif hyperfréquence selon l'une des revendications 1 à 3, **caractérisé en ce que** chaque cellule amplificatrice est réalisée à base de transistors tels que les transistors bipolaires ou les transistors à effet de champ.

5. Dispositif hyperfréquence selon l'une des revendications 1 à 4, **caractérisé en ce que** le commutateur (C2) est réalisé par au moins deux transistors.

6. Dispositif hyperfréquence selon l'une des revendications 1 à 5, **caractérisé en ce que** le commutateur (C2) est réalisé à l'aide de deux transistors à effet de champ (TECs) froids, un TEC T1 connecté par son drain D à l'autre extrémité (Em) de la ligne de transmission d'entrée (Lg) du signal d'entrée et par sa source S à la sortie S de signal hyperfréquences, un TEC T2 connecté par son drain D à l'extrémité (Sd) de sortie de l'amplificateur distribué et par sa source S à ladite sortie S de signal hyperfréquences et, **en ce qu'**un TEC T3 est connecté par son drain au point commun entre l'extrémité (Em) de la ligne de transmission d'entrée (Lg) et le drain du TEC T1 par l'intermédiaire d'une impédance de fermeture (Zg) de la ligne de transmission d'entrée (Lg) et, par sa source, à un potentiel de référence (M).

## Patentansprüche

1. Breitband-Mikrowellenvorrichtung mit schaltbarer Verstärkung, die einen Mikrowellensignaleingang E und einen Mikrowellensignalausgang S, einen verteilten Verstärker mit n Verstärkerzellen (Cl1, Cl2, ... Cli, ... Cln) umfasst, der eine Eingangsübertragungsleitung (Lg) eines Eingangssignals (Ue) umfasst, das an den Mikrowellensignaleingang E angelegt wird, wobei eines der zwei Enden (ec1) der Eingangsübertragungsleitung mit dem Mikrowellensignaleingang E verbunden ist, wobei eine Ausgangsübertragungsleitung (Ld) des verstärkten Eingangssignals (Ue) ein Ausgangsende (Sd) des verteilten Verstärkers hat, wobei die Verstärkerzellen des verteilten Verstärkers entweder in einen Verstärkungszustand oder in einen Sperrzustand gesetzt werden können,
**dadurch gekennzeichnet, dass** sie einen Zwei-auf-einen-Kanal-Schalter (C2) mit einem Steuereingang (Ct) umfasst, zum Schalten entweder in eine Nicht-Verstärkungsposition, in der somit der Mikrowellensignalausgang S mit dem anderen Ende (Em) der Eingangsübertragungsleitung verbunden ist, um das Eingangssignal (Ue) zum Ausgang S zu senden, oder in eine Verstärkungsposition, in der der Signalausgang S mit dem Ausgangsende (Sd) des verteilten Verstärkers verbunden ist, um ein verstärktes Eingangssignal (Ue) zum Mikrowellensignalausgang S zu senden, wobei eine Steuereinheit UC Signale zum Steuern der Position des Zwei-auf-einen-Kanal-Schalters (C2) und des Zustands der Verstärkerzellen liefert.

2. Mikrowellenvorrichtung nach Anspruch 1, **dadurch gekennzeichnet, dass** jede Verstärkerzelle Folgendes umfasst: einen Mikrowelleneingang (ec1) und einen Mikrowellenausgang (es1) des verstärkten Signals, einen Steuereingang (cmc1, cmc2), um entweder in den Verstärkerzustand gesetzt zu werden und ein verstärktes Signal am Mikrowellenausgang der Zelle (sc2) bereitzustellen, oder in den Sperrzustand, um den Ausgang (es1) der Zelle von ihrem Eingang (ec1) zu isolieren.

3. Mikrowellenvorrichtung nach Anspruch 1 oder 2, **dadurch gekennzeichnet, dass** sie eine Abschlussimpedanz (Zg) umfasst, und dadurch, dass, wenn der Zwei-auf-einen-Kanal-Schalter (C2) in der Verstärkungsposition ist, die Verstärkungszellen in den Verstärkungszustand gesetzt werden, wobei das andere Ende (Em) der Eingangsübertragungsleitung (Lg) mit einem Referenzpotential (M) über die Abschlussimpedanz (Zg) verbunden ist, und wenn der Schalter in der Nicht-Verstärkungsposition ist, die Verstärkungszellen in den Sperrzustand gesetzt werden, wobei das Ende (Em) der Eingangsübertragungsleitung (Lg) dann von der Abschlussimpedanz (Zg) abgetrennt ist.

4. Mikrowellenvorrichtung nach einem der Ansprüche 1 bis 3, **dadurch gekennzeichnet, dass** jede Verstärkungszelle auf der Basis von Transistoren wie z.B. bipolaren Transistoren oder Feldeffekttransistoren realisiert wird.

5. Mikrowellenvorrichtung nach einem der Ansprüche 1 bis 4, **dadurch gekennzeichnet, dass** der Schalter (C2) durch wenigstens zwei Transistoren realisiert wird.

6. Mikrowellenvorrichtung nach einem der Ansprüche 1 bis 5, **dadurch gekennzeichnet, dass** der Schalter (C2) mit Hilfe von zwei kalten Feldeffekttransistoren (TECs) realisiert wird, einem TEC T1, der über seinen Drain D mit dem anderen Ende (Em) der Eingangsübertragungsleitung (Lg) des Eingangssignals und mit seiner Source S mit dem Mikrowellensignalausgang S verbunden ist, einem TEC T2, der über seinen Drain D mit dem Ausgangsende (Sd) des verteilten Verstärkers und mit seiner Source S mit dem Mikrowellensignalausgang S verbunden ist, und dadurch, dass ein TEC T3 mit seinem Drain mit dem gemeinsamen Punkt zwischen dem Ende (Em) der Eingangsübertragungsleitung (Lg) und dem Drain des TEC T1 über eine Abschlussimpedanz (Zg) der Eingangsübertragungsleitung (Lg) und mit seiner Source mit einem Referenzpotential (M) verbunden ist.

## Claims

1. Broadband microwave device with switchable gain comprising a microwave signal input E and output S, a distributed amplifier with n amplifying cells (Cl1, Cl2,...Cli,...Cln) comprising an input transmission line (Lg) for an input signal (Ue) applied to the microwave signal input E, said input transmission line having one of its two ends (ec1) linked to the microwave signal input E, an output transmission line (Ld) for said amplified input signal (Ue) having an output end (Sd) of the distributed amplifier, the amplifying cells of the distributed amplifier being able to be set either in an amplifying state or in a blocked state,
**characterized in that** it comprises a two-channel-to-one-channel switch (C2) comprising a control input (Ct) to be switched, either to a non-amplification position then linking the microwave signal output S to the other end (Em) of the input transmission line to transmit to said output S the input signal (Ue), or to an amplification position linking said signal output S to the output end (Sd) of the distributed amplifier, to transmit to the microwave signal output S an amplified input signal (Ue), a control unit UC supplying two-channel-to-one-channel switch (C2) position and amplifying cell status control signals.

2. Microwave device according to Claim 1, **characterized in that** each amplifying cell comprises an amplified signal microwave input (ec1) and output (es1), a control input (cmc1, cmc2) to be set, either to an amplifying state and supply an amplified signal at the microwave output of the cell (sc2), or to a blocked state to isolate the output (es1) of the cell from its input (ec1).

3. Microwave device according to one of Claims 1 or 2, **characterized in that** it includes a terminating impedance (Zg) and **in that**, when the two-channel-to-one-channel switch (C2) is in the amplification position, the amplifying cells are set to the amplifying state, the other end (Em) of the input transmission line (Lg) being connected to a reference potential (M) via the terminating impedance (Zg) and, when the switch is in the non-amplification position, the amplifying cells are set to the blocked state, the end (Em) of the input transmission line (Lg) then being disconnected from the terminating impedance (Zg).

4. Microwave device according to one of Claims 1 to 3, **characterized in that** each amplifying cell is produced on the basis of transistors such as bipolar transistors or field-effect transistors.

5. Microwave device according to one of Claims 1 to 4, **characterized in that** the switch (C2) is produced by at least two transistors.

6. Microwave device according to one of Claims 1 to 5, **characterized in that** the switch (C2) is produced using two cold field-effect transistors (FET), an FET T1 connected by its drain D to the other end (Em) of the input transmission line (Lg) for the input signal and by its source S to the microwave signal output S, an FET T2 connected by its drain D to the output end (Sd) of the distributed amplifier and by its source S to said microwave signal output S, and **in that** an FET T3 is connected by its drain to the common point between the end (Em) of the input transmission line (Lg) and the drain of the FET T1 via a terminating impedance (Zg) of the input transmission line (Lg) and by its source to a reference potential (M).
